# FASCICULE DE BREVET EUROPEEN

(11) **EP 0 693 865 B1**
(45) Date de publication et mention de la délivrance du brevet: **10.06.1998**
(21) Numéro de dépôt: 95401693.7
(22) Date de dépôt: 17.07.1995
(51) Int. Cl.: H05H 1/26, H05H 1/30

(54) **Torche à plasma par induction**
Induktionplasmabrenner
Induction plasma torch

(30) Priorité: 22.07.1994 FR 9409106
(43) Date de publication de la demande: 24.01.1996
(73) Titulaire: ALCATEL ALSTHOM COMPAGNIE GENERALE D'ELECTRICITE, 75008 Paris (FR)
(72) Inventeur: Jouvenel, Bernard, F-91400 Bures Sur Yvette (FR); Ripoche, Pierre, F-45300 Pithiviers (FR)
(74) Mandataire: Pothet, Jean Rémy Emile Ludovic

(56) Documents cités:
- EP-A- 0 458 205
- WO-A-92/19086
- WO-A-94/16859
- US-A- 3 999 835
- US-A- 4 716 572
- US-A- 5 004 629
- US-A- 5 023 109
- US-A- 5 252 892
- PATENT ABSTRACTS OF JAPAN vol. 13 no. 117 (E-731), 22 Mars 1989 & JP-A-63 289 798
- PATENT ABSTRACTS OF JAPAN vol. 14 no. 509 (C-0776), 7 Novembre 1990 & JP-A-02 211 245
- DATABASE WPI Week 8215, Derwent Publications Ltd., London, GB; AN 82-29283e & JP-A-57 038 368
- PATENT ABSTRACTS OF JAPAN vol. 17 no. 222 (M-1404), 7 Mai 1993 & JP-A-04 356 341
- PATENT ABSTRACTS OF JAPAN vol. 10 no. 164 (E-410) [2220], 11 Juin 1986 & JP-A-61 016 524

## Description

La présente invention concerne une torche à plasma par induction, plus particulièrement du type utilisé dans les procédés de dépôt par plasma de silice pure ou dopée lors de la fabrication de préformes pour fibre optique.

Les torches à plasma sont bien connues dans le domaine de la fabrication de préformes pour fibre optique. Elles comprennent principalement les éléments suivants :
- un tube, en général à base de silice, dit tube de réaction, à l'intérieur duquel se trouve une zone de production du plasma,
- des moyens de distribution de gaz plasmagènes (tels que l'argon, l'oxygène, l'azote, l'air, etc...) dans ce tube,
- des moyens d'injection dans ce tube des réactifs (solides, liquides ou gazeux) utilisés pour effectuer le dépôt,
- une bobine d'induction entourant ce tube, pour apporter l'énergie nécessaire à la formation du plasma, cette bobine étant alimentée à cet effet par un générateur haute fréquence.

Le principe de fonctionnement d'une telle torche dans le cadre de la fabrication d'une préforme pour fibre optique est le suivant. Dans le but d'obtenir une préforme de diamètre final important (pour pouvoir ensuite étirer des longueurs importantes de fibre optique), on effectue à l'aide d'une torche à plasma la recharge d'une préforme obtenue par ailleurs par une méthode classique telle que les méthodes MCVD, OVD, VAD, etc... A cet effet, on introduit dans le tube de réaction des réactifs destinés à constituer les couches à déposer sur la préforme, ainsi que des gaz plasmagènes. Le dépôt est effectué grâce à l'énergie apportée par la bobine d'induction, couplée à la zone de production du plasma à l'intérieur du tube.

La structure de la torche à plasma qui vient d'être décrite est l'une des plus simples ; une telle torche est dénommée torche monotube à simple flux (car les gaz sont introduits axialement dans le tube). Elle est utilisable à des puissances allant jusqu'à 10 à 15 kW.

Il existe d'autres structures de torches à plasma plus complexes, dont le principe de fonctionnement est sensiblement le même que celui de la torche monotube à simple flux, et dont on donne ci-après deux exemples :
- la torche monotube à double flux, dans laquelle les gaz sont introduits axialement et latéralement dans le tube de réaction, et qui est utilisable à des puissances allant jusqu'à 25 à 30 kW,
- la torche à triple paroi, constituée de trois tubes disposés coaxialement l'un dans l'autre, le tube interne étant le tube de réaction, à l'intérieur duquel se trouve la zone de production du plasma ; cette torche est refroidie par circulation d'eau entre ses parois, et peut fonctionner à des puissances allant jusqu'à 150 kW.

La présente invention s'applique à tous les types de torches à plasma adaptées à la fabrication de préformes pour fibre optique, et comprenant un tube de réaction à base de silice.

Dans tous les cas, ce tube de réaction, qui est immédiatement au voisinage du plasma, est soumis à des températures extrêmement élevées pouvant dépasser 1000°C (la température du plasma étant de 5000 à 10000°C), ce qui lui est bien entendu fort préjudiciable, car cela conduit à sa défaillance mécanique (apparition de fissures), puis à sa rupture.

Pour éviter cela, surtout lorsque l'on travaille à des puissances très élevées, on a pensé à utiliser un système de refroidissement par circulation d'eau dans une torche à triple paroi, telle que décrite ci-dessus.

Cependant, ceci ne s'est pas avéré satisfaisant, car on constate encore une rupture du tube de réaction à court terme dans de telles torches.

Ainsi, en pratique, on a observé que les torches à plasma par induction utilisées en continu pendant de nombreuses heures d'affilée pour la fabrication de préformes pour fibres optiques avaient une durée de vie maximale de 100 heures environ, avec une durée de vie moyenne de l'ordre de quelques dizaines d'heures, en général 50 heures.

Or, une fois le tube de réaction rompu, il faut interrompre la fabrication pendant plusieurs heures afin de régler à nouveau les conditions opératoires. Ceci entraîne une réduction du temps de production du dispositif, et donc une diminution de la productivité de ce dernier. En outre, le remplacement de la torche est onéreux. Enfin, en général, la rupture de la torche abîme la préforme en cours de fabrication, qui devient donc inutilisable, ce qui représente une perte significative de production.

On comprend donc bien qu'il est indispensable d'accroître la durée de vie des torches à plasma connues.

La demande de brevet JP 63-289798 propose, pour lutter contre les chocs thermiques, c'est-à-dire les ruptures accidentelles du tube de réaction dues au fait que le plasma vient en contact direct avec la paroi de ce dernier, de déposer sur cette paroi un revêtement absorbant la chaleur par sublimation ; de cette manière, lorsque le plasma, accidentellement, vient au contact de ce revêtement, le matériau le constituant se sublime et empêche donc ainsi le contact direct du plasma et de la paroi interne. Cette solution est adaptée aux cas des torches utilisées en laboratoire pour effectuer des essais, c'est-à-dire ne fonctionnant pas en continu durant de nombreuses heures d'affilée.

Toutefois, une telle méthode ne convient pas pour résoudre le problème de la rupture des tubes de réaction, telle qu'observée après de nombreuses heures d'utilisation de la torche. En effet, une fois que le matériau du revêtement protecteur s'est sublimé après un ou plusieurs chocs thermiques accidentels, la paroi interne du tube de réaction est de nouveau soumise à des températures très élevées ; pour que la protection soit efficace, il faudrait en permanence reconstituer la couche de revêtement protecteur qui a disparu du fait de la sublimation. On comprend bien qu'une telle solution n'est pas applicable industriellement, puisqu'elle demande l'arrêt total de la fabrication pendant quelques heures, et entraîne donc une diminution du rendement inacceptable.

Une autre solution pour rendre cette protection efficace serait d'utiliser un revêtement protecteur d'épaisseur relativement importante, en pratique au moins 5 mm. Ceci est tout à fait préjudiciable au fonctionnement de la torche, car alors, il faut augmenter de façon importante la puissance du générateur relié à la bobine d'induction pour obtenir à l'intérieur du tube de réaction l'apport d'énergie désiré, du fait de la perte de couplage entre le plasma et la bobine d'induction, et donc de la perte de rendement du générateur.

De plus, le revêtement de forte épaisseur a tendance à augmenter statistiquement les risques que le plasma vienne au contact du tube, puisque le plasma a tendance à se rapprocher de la paroi, celle-ci étant moins bien refroidie du fait de son épaisseur trop importante.

Ainsi, la solution proposée dans cette demande japonaise ne permet pas de résoudre le problème posé, c'est-à-dire d'augmenter la durée de vie des torches à plasma.

La présente invention a donc pour objet de mettre au point une torche à plasma par induction qui a une durée de vie supérieure à celle des torches de l'art antérieur.

Un autre but de la présente invention est de mettre au point une telle torche qui ne rend pas nécessaire une augmentation de la puissance nécessaire au niveau du générateur haute fréquence.

Enfin, un autre but de la présente invention est de mettre au point une telle torche qui évite les interruptions répétées de la production.

La présente invention propose à cet effet une torche à plasma par induction du type utilisé dans les procédés de dépôt par plasma de silice pure ou dopée lors de la fabrication de préformes pour fibre optique, comprenant :
- un tube, dit tube de réaction, à l'intérieur duquel se trouve une zone de production du plasma,
- des moyens d'injection dans ledit tube, vers ladite zone de production du plasma, des réactifs destinés à former la silice pure ou dopée à déposer,
- des moyens de distribution de gaz plasmagènes à l'intérieur dudit tube vers ladite zone de production du plasma,
- une bobine d'induction entourant ledit tube, pour apporter l'énergie nécessaire à la formation dudit plasma,
caractérisée en ce que ledit tube est protégé contre les cycles thermiques dus aux variations de la température à l'intérieur dudit tube au moyen d'un revêtement déposé sur la paroi interne dudit tube de réaction au niveau de ladite zone de production du plasma, de manière à entourer cette dernière, ledit revêtement étant constitué d'un matériau à base de silice et ayant une épaisseur inférieure à 2 mm.

La solution de l'invention provient de la constatation suivante. Les ruptures à court terme des tubes de réaction des torches de l'art antérieur ne proviennent pas de chocs thermiques accidentels. Ces chocs thermiques accidentels sont relativement rares, et sont en fait très bien maîtrisés par le contrôle de l'introduction des gaz dans le tube de réaction, qui permet de maintenir la flamme du plasma centrée dans ce dernier, et donc de l'empêcher de venir au contact de ses parois.

Ces ruptures ne proviennent pas non plus du fait que la paroi est soumise à des températures très élevées, de l'ordre de quelques milliers de °C.

En revanche, la Demanderesse a constaté que la rupture à court terme des tubes de réaction utilisés est due en réalité aux cycles thermiques répétés que subit la paroi interne du tube de réaction.

En effet, cette paroi interne, qui entoure le plasma, est maintenue à une température élevée, supérieure à 1000°C au cours de certaines phases d'utilisation de la torche à puissance élevée, pouvant atteindre 100 kW. Cette utilisation, tout à fait normale, ne crée pas, ainsi que l'on vient de l'exposer, de dommages pour la torche, tels que des chocs thermiques. Cependant, cette utilisation à haute température a tendance à modifier la structure du verre de silice constituant le tube de réaction, par un phénomène dénommé "dévitrification" ou "recristallisation".

Ce phénomène est le suivant. L'utilisation à température supérieure à 1000°C pendant plusieurs heures d'affilée entraîne, à la surface de la paroi interne du tube de réaction, la transformation de la silice le constituant en cristaux appelés cristobalite β, c'est-à-dire la cristallisation de la silice. L'épaisseur de la couche de cristobalite β ainsi formée croît avec le temps pendant lequel la paroi est soumise à une température supérieure à 1000°C. A cette température, la densité de la cristobalite β diffère très peu de celle de la silice vitreuse. Ainsi, tant que cette température est maintenue, aucun effet dommageable n'est encouru par le tube. C'est pourquoi la Demanderesse a découvert que le problème de la durée de vie réduite de la torche n'est pas dû au fait que le tube intérieur de cette dernière est soumis à des températures élevées, contrairement à ce que l'on pensait jusqu'alors.

En revanche, lorsque la torche est refroidie, soit par arrêt du plasma, soit du fait de cycles thermiques suivis en cours d'utilisation et faisant descendre la température en-dessous de 250°C environ, cette température étant la température de transformation allotropique de la cristobalite β en cristobalite α, on observe donc une inversion de phase cristalline de la cristobalite qui s'accompagne d'une variation de sa densité ; ainsi, le volume spécifique de la cristobalite s'accroît d'environ 5% lors de cette transformation. Cette forte expansion volumique développe au sein du tube des tensions internes très élevées, qui engendrent des microfissures ainsi que des failles superficielles agissant à la manière de concentrateurs de contraintes dans le tube. Ces contraintes sont d'autant plus importantes que, de manière générale, le tube de réaction de la torche est maintenu à sa base dans un support qui l'enserre et crée donc des contraintes supplémentaires. C'est l'ensemble de ces contraintes qui conduit à la défaillance mécanique du tube puis à sa rupture. On assiste en fait à un vieillissement prématuré du tube.

Ainsi, la solution de l'invention provient de la découverte de l'origine du problème causant une rupture à court terme du tube de réaction de la torche, résidant dans le fait que ce dernier subit des cycles thermiques.

La solution de l'invention consiste à faire subir le phénomène de dévitrification non pas à la paroi interne du tube de réaction, mais à un revêtement déposé sur elle. Pour cela, ce revêtement doit être à base de silice, et il sert d'écran thermique. Etant donné que le phénomène de dévitrification est principalement un phénomène de surface, une faible épaisseur de revêtement est suffisante pour protéger le tube, de sorte qu'une épaisseur importante, nécessaire lorsque l'on souhaite éviter les chocs thermiques, et qui, comme on l'a vu, est préjudiciable au rendement du générateur haute fréquence, est inutile pour obtenir le résultat procuré par l'invention.

Etant donné que le revêtement protecteur ne subit pas les contraintes du support mécanique du tube, il se dégrade plus lentement que la paroi interne du tube de réaction qui serait soumise à ces contraintes. La durée de vie de la torche selon l'invention est donc augmentée environ de la durée nécessaire à la dégradation totale du revêtement protecteur.

On a observé que les torches selon l'invention ont une durée de vie moyenne d'environ 600 heures, et que des durées de vie supérieures à 1000 heures sont régulièrement atteintes.

Par ailleurs, le revêtement protecteur n'a pas besoin d'être reconstitué, puisqu'il ne se sublime pas ; en effet, étant donné son épaisseur, il accroche bien à la paroi interne du tube et a donc peu de risques de se sublimer. Il n'est en outre pas choisi pour cela, notamment quant à sa chaleur latente de sublimation. D'ailleurs, il est tout à fait indésirable qu'une sublimation se produise, non seulement pour éviter d'avoir à reconstituer le revêtement protecteur, mais aussi car cela aurait en outre tendance à contaminer les dépôts effectués lors de la fabrication de la préforme, ce qui conduirait à une dégradation des performances des fibres optiques obtenues (augmentation de leur l'atténuation). C'est pour cette raison notamment que l'on choisit un matériau à base de silice pour le revêtement protecteur. La torche selon l'invention est donc utilisable industriellement sans problème.

De manière avantageuse, le revêtement protecteur est constitué de silice opaque, non fondue et donc poreuse. Ceci permet de réduire l'influence de l'expansion volumique due à la transformation en cristobalite α, de sorte que la paroi interne du tube ne subit pratiquement pas les conséquences de cette expansion volumique.

D'autres caractéristiques et avantages de la présente invention apparaîtront dans la description suivante d'une torche à plasma selon l'invention et d'un procédé de réalisation d'un revêtement protecteur d'une telle torche, donnés à titre illustratif et nullement limitatif.

Dans les figures suivantes :
- la figure 1 est une vue très schématique en coupe longitudinale d'une torche à plasma selon l'invention,
- la figure 2 est une vue agrandie du détail II de la figure 1.

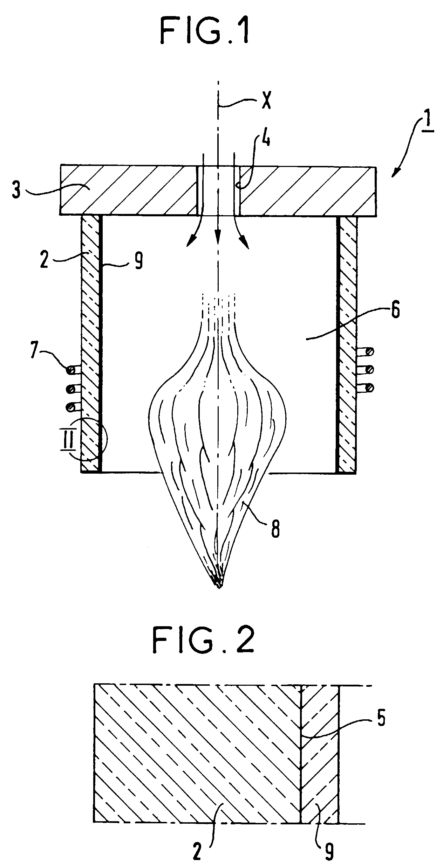

On voit à la figure 1 une torche à plasma 1 selon l'invention, cette torche 1 étant une torche monotube à simple flux. Elle est destinée à être utilisée pour la fabrication de préformes pour fibre optique.

Elle comprend un tube de réaction 2 en verre de silice (ou quartz). En effet, il est préférable que le tube 2 soit en un matériau le plus pur possible et proche de celui à déposer, afin de ne pas contaminer la préforme en cours de réalisation par d'éventuelles impuretés, ces impuretés risquant d'entraîner une augmentation de l'atténuation des fibres obtenues à partir de cette préforme.

Le tube 2 est fermé à l'une de ses extrémités par des moyens de distribution de gaz 3, présentant une ouverture axiale 4 selon l'axe X du tube 2. Ces moyens de distribution 3 servent à amener dans la zone de réaction 6 se trouvant à l'intérieur du tube de réaction 2 le ou les gaz plasmagènes (argon, oxygène, azote, air, etc...) qui servent à entretenir le plasma sous l'effet des courants d'induction générés par une bobine d'induction 7, entourant le tube 2 et d'axe confondu avec l'axe X, cette bobine étant reliée à un générateur haute fréquence (non représenté).

Un dispositif d'injection (non représenté) dans le plasma des réactifs (solides, liquides ou gazeux) destinés à constituer le matériau à déposer (ce matériau étant de la silice pure ou dopée, par exemple au moyen de constituants servant à modifier son indice de réfraction), est disposé à l'intérieur et/ou à l'extérieur du tube de réaction 2.

La flamme du plasma a été représentée schématiquement sur la figure où elle porte le numéro de référence 8.

Selon l'invention, la paroi interne 5 du tube de réaction 2 est recouverte, sur une partie de sa longueur correspondant à la zone de production du plasma 6, d'un revêtement de protection 9 entourant cette zone. Ce revêtement 9 sert à éviter que le tube 2 subisse directement les cycles thermiques dus aux variations de la température au sein de la zone de production du plasma 6, entre la température du plasma, supérieure à la température de formation de cristobalite β, et celle de refroidissement en-dessous de la température de transformation allotropique de la cristobalite β en cristobalite α.

Le revêtement 9 est constitué d'un matériau à base de silice et a une épaisseur inférieure à 2 mm, pour les raisons qui ont été exposées plus haut.

Enfin, dans le cas des torches refroidies par eau, le tube de réaction 2 est entouré d'une enceinte (non représentée) pour la circulation du liquide de refroidissement, cette enceinte pouvant être en silice ou en tout autre matériau adapté (céramique ou polymérique par exemple), l'ensemble constitué par le tube de réaction 2 et l'enceinte étant alors serti dans un support commun.

Un procédé possible pour la réalisation du revêtement 9 est maintenant décrit.

En premier lieu, on met en suspension dans de l'eau tamponnée (à pH = 9 par exemple) un mélange de silice et d'alumine Al₂O₃ dans des proportions respectives de 70% et de 30% en poids. On obtient ainsi une solution appelée "barbotine".

Ensuite, on nettoie la paroi interne 5 du tube de réaction 2 à l'alcool. Un nettoyage très soigneux est nécessaire car en pratique, la formation de cristobalite commence par la formation d'un germe cristallin stable à partir de germes accidentels, tels que des dépôts alcalins sur la paroi interne 5 du tube 2, des salissures dues aux traces de doigts, des marques d'eau, des contaminants contenus dans l'air, etc... Ce phénomène s'appelle la nucléation. Après cette phase de nucléation, le développement de la cristobalite commence, et il est d'autant plus rapide que la paroi interne 5 du tube 2 est contaminée.

Après le nettoyage, on obture le tube 2 à l'une de ses extrémités, puis l'on introduit la barbotine par l'autre extrémité, en prenant soin d'incliner le tube 2 et de le faire tourner simultanément (par exemple à une vitesse de 1 tr/s) autour de son axe X afin d'enduire sa surface intérieure d'une fine pellicule de la barbotine.

Ensuite, on retire le bouchon ayant servi à obturer le tube 2, puis on laisse dégorger le matériau ainsi déposé en continuant de tourner.

On place alors le tube sur un tour dans un endroit ventilé pour effectuer le séchage de la pellicule déposée à l'air ambiant, tout en continuant de faire tourner le tube 2 à environ 1 tr/s autour de son axe X. Ce séchage dure environ 5 heures.

On effectue ensuite un séchage dans un four pendant 2 heures à 300°C. Cette température est telle que la fusion du matériau déposé ne se produit pas, de sorte que le revêtement 9 ainsi obtenu est poreux.

Lorsque la barbotine est constituée de silice sensiblement pure, à au moins 95% (compte tenu des impuretés et des liants), le séchage au four a lieu à environ 1100°C, cette température étant inférieure à celle du recuit de la silice.

L'utilisation d'une barbotine permet de revêtir le tube 2 d'une couche très fine, n'excédant pas en pratique 2 mm d'épaisseur, et de préférence inférieure à 0,5 mm d'épaisseur.

Grâce à l'utilisation d'une barbotine, en outre, le revêtement protecteur accroche bien sur la paroi interne 5 du tube 2, ce que l'on vérifie une fois le procédé terminé en envoyant de l'air comprimé dans le tube : la couche ne subit aucun dommage. Ceci est particulièrement important, car lors de l'établissement du plasma dans le tube 2 pour la mise en marche de la torche 1, un souffle de grande amplitude se produit, risquant d'endommager le revêtement 9, ce qui est bien sûr fort préjudiciable au bon fonctionnement de ce revêtement.

D'autre part, l'accrochage obtenu grâce à la barbotine est juste suffisant pour que la dévitrification du revêtement 9 ne se propage pas au niveau de la paroi interne 5 du tube 2.

Les avantages précédents peuvent également être obtenus en utilisant une solution gélifiante ou colloïdale de silice.

Il est important que le matériau constituant le revêtement 9 soit à base de silice, afin d'éviter toute contamination des matériaux à déposer lors d'une éventuelle décomposition de ce revêtement.

Bien entendu, la présente invention n'est pas limitée au mode de réalisation qui vient d'être décrit.

Notamment, le procédé utilisé pour déposer le revêtement protecteur sur la paroi interne du tube de réaction peut être quelconque, du moment qu'il permet de déposer les épaisseurs souhaitées.

Par ailleurs, la solution de départ utilisée peut se présenter sous une forme quelconque, et pas nécessairement sous la forme d'une barbotine, du moment que la composition du revêtement déposé est à base de silice.

Enfin, on pourra remplacer tout moyen par un moyen équivalent sans sortir du cadre de l'invention.

## Revendications

1. Torche à plasma par induction du type utilisé dans les procédés de dépôt par plasma de silice pure ou dopée lors de la fabrication de préformes pour fibre optique, comprenant :
- un tube (2), dit tube de réaction, à l'intérieur duquel se trouve une zone de production du plasma (6),
- des moyens d'injection dans ledit tube (2), vers ladite zone de production du plasma (6), des réactifs destinés à former la silice pure ou dopée à déposer,
- des moyens de distribution (4) de gaz plasmagènes à l'intérieur dudit tube (2) vers ladite zone de production du plasma (6),
- une bobine d'induction (7) entourant ledit tube (2), pour apporter l'énergie nécessaire à la formation dudit plasma (8),
caractérisée en ce que ledit tube (2) est protégé contre les cycles thermiques dus aux variations de la température à l'intérieur dudit tube au moyen d'un revêtement protecteur (9) déposé sur la paroi interne (5) dudit tube de réaction (2) au niveau de ladite zone de production du plasma (6), de manière à entourer cette dernière, ledit revêtement (9) étant constitué d'un matériau à base de silice et ayant une épaisseur inférieure à 2 mm.

2. Torche à plasma selon la revendication 1 caractérisée en ce que ledit revêtement protecteur (9) est constitué d'un matériau à base de silice opaque, n'ayant pas subi de fusion et poreuse.

3. Torche à plasma selon l'une des revendications 1 ou 2 caractérisée en ce que l'épaisseur dudit revêtement protecteur (9) est de l'ordre de 0,5 mm.

4. Torche à plasma selon l'une des revendications 1 à 3 caractérisée en ce que ledit revêtement protecteur (9) est constitué de silice pure à au moins 95%, les 5% restants correspondant notamment aux impuretés et aux liants.

5. Torche à plasma selon l'une des revendications 1 à 3 caractérisée en ce que ledit revêtement protecteur (9) est constitué d'un mélange de silice et d'alumine Al₂O₃, dans des proportions respectives de 70% et de 30% en poids.

6. Procédé de réalisation d'un revêtement protecteur d'une torche à plasma selon l'une des revendications 1 à 5 caractérisé en ce qu'il comprend les opérations suivantes :
- nettoyage de la surface intérieure du tube,
- enduction de la paroi interne dudit tube à l'aide du matériau constituant ledit revêtement protecteur, contenant de la silice en solution aqueuse, colloïdale ou gélifiante, pour obtenir une fine pellicule,
- séchage à l'air ambiant de ladite pellicule,
- séchage dans un four de ladite pellicule à une température inférieure à celle de fusion du matériau la constituant.

7. Procédé selon la revendication 6 caractérisé en ce que ladite solution est une barbotine liquide de silice, et en ce que, préalablement à l'opération d'enduction, l'une des extrémités dudit tube est obturée, et ladite barbotine est introduite dans ledit tube par son autre extrémité, l'obturation étant supprimée après ladite enduction.

8. Procédé selon l'une des revendications 6 ou 7 caractérisé en ce que, pendant ladite enduction, ledit tube est mis en rotation autour de son axe.

9. Procédé selon l'une des revendications 6 à 8 caractérisé en ce que, pendant lesdits séchages, ledit tube est mis en rotation autour de son axe.

## Patentansprüche

1. Induktionsplasmabrenner desjenigen Typs, der bei Verfahren zur Abscheidung von reinem oder dotiertem Kieselsäureanhydrid durch Plasma bei der Herstellung von Vorformlingen für Lichtleitfasern verwendet wird, mit:
- einer Röhre (2), Reaktionsröhre genannt, in deren Innerem sich eine Zone (6) für die Herstellung des Plasmas befindet,
- Injektionsmitteln in der Röhre (2) zur Zone (6) für die Herstellung des Plasmas hin für die Reagenzien, die dazu bestimmt sind, das abzuscheidende reine oder dotierte Kieselsäureanhydrid zu bilden,
- Verteilungsmitteln (4) für Plasmidgase im Inneren der Röhre (2) zur Zone (6) für die Herstellung des Plasmas hin,
- einem die Röhre (2) umgebenden Induktor (7), um die für die Bildung des Plasmas (8) notwendige Energie zuzuführen,
**dadurch gekennzeichnet,** daß die Röhre (2) gegen Wärmezyklen aufgrund von Änderungen der Temperatur im Inneren der Röhre mittels einer Schutzauskleidung (9) geschützt ist, die an der Innenwand (5) der Reaktionsröhre (2) in Höhe der Zone (6) für die Herstellung des Plasmas so abgeschieden ist, daß sie diese letztere umgibt, wobei die Auskleidung (9) aus einem Material auf der Basis von Kieselsäureanhydrid besteht und eine Dicke kleiner als 2 mm aufweist.

2. Plasmabrenner nach Anspruch 1, dadurch gekennzeichnet, daß die Schutzauskleidung (9) aus einem Material auf der Basis von lichtundurchlässigem Kieselsäureanhydrid besteht, das keinem Schmelzvorgang unterzogen wurde und porös ist.

3. Plasmabrenner nach einem der Ansprüche 1 oder 2, dadurch gekennzeichnet, daß die Dicke der Schutzauskleidung (9) in der Größenordnung von 0,5 mm liegt.

4. Plasmabrenner nach einem der Ansprüche 1 bis 3, dadurch gekennzeichnet, daß die Schutzauskleidung (9) aus zu mindestens 95% reinem Kieselsäureanhydrid besteht, wobei die übrigen 5% insbesondere Verunreinigungen und Bindemitteln entsprechen.

5. Plasmabrenner nach einem der Ansprüche 1 bis 3, dadurch gekennzeichnet, daß die Schutzauskleidung (9) aus einer Mischung aus Kieselsäureanhydrid und Aluminiumoxid Al₂O₃ in den Verhältnissen 70 Gew.-% bzw. 30 Gew.-% besteht.

6. Verfahren zum Herstellen einer Schutzauskleidung eines Plasmabrenners nach einem der Ansprüche 1 bis 5,
dadurch gekennzeichnet, daß es die folgenden Schritte umfaßt:
- Reinigung der Innenfläche der Röhre,
- Beschichtung der Innenwand der Röhre mit Hilfe des die Schutzschicht bildenden Materials, das das Kieselsäureanhydrid in wäßriger, kolloidaler oder gelierender Lösung enthält, um einen dünnen Überzug zu erhalten,
- Trocknen des Überzugs mit Umgebungsluft,
- Trocknen des Überzugs in einem Ofen bei einer Temperatur, die niedriger als der Schmelzpunkt des ihn bildenden Materials ist.

7. Verfahren nach Anspruch 6, dadurch gekennzeichnet, daß die Lösung ein flüssiger Kieselsäureanhydridschlicker ist, und daß vor dem Beschichtungsschritt eines der Enden der Röhre verschlossen und der Schlicker an ihrem anderen Ende in die Röhre eingeführt wird, wobei der Verschluß nach der Beschichtung beseitigt wird.

8. Verfahren nach einem der Ansprüche 6 oder 7, dadurch gekennzeichnet, daß die Röhre während der Beschichtung in Rotation um ihre Achse versetzt wird.

9. Verfahren nach einem der Ansprüche 6 bis 8, dadurch gekennzeichnet, daß die Röhre während der Trocknungen in Rotation um ihre Achse versetzt wird.

## Claims

1. An induction plasma torch of the type used in plasma deposition methods for depositing pure or doped silica when manufacturing preforms for optical fibers, said plasma torch comprising:
a "reaction" tube (2) inside which a plasma production zone (6) is located;
means for injecting reagents for forming the pure or doped silica to be deposited into said tube (2) towards the plasma production zone (6);
feed means (4) for feeding plasma-generating gases into said tube (2) towards said plasma production zone (6); and
an induction coil (7) surrounding said tube (2) for supplying the energy required to form said plasma (8);
said plasma torch being characterized in that said tube (2) is protected against the thermal cycles due to variations in the temperature inside said tube by means of a protective lining (9) deposited on the inside wall (5) of said reaction tube (2) at said plasma production zone (6) so as to surround said zone, said lining (9) being made of a material based on silica, and having a thickness of less than 2 mm.

2. A plasma torch according to claim 1, characterized in that said protective lining (9) is made of a material based on opaque silica that has not undergone any fusion, and that is porous.

3. A plasma torch according to claim 1 or 2, characterized in that the thickness of said protective lining (9) is about 0.5 mm.

4. A plasma torch according to any one of claims 1 to 3,
characterized in that said protective lining (9) is made of silica that is at least 95% pure, the remaining 5% corresponding in particular to impurities and to binders.

5. A plasma torch according to any one of claims 1 to 3,
characterized in that said protective lining (9) is made of a mixture of silica and of alumina Al₂O₃, in respective proportions by weight of 70% and of 30%.

6. A method of making a protective lining for a plasma torch according to any one of claims 1 to 5, characterized in that it includes the following steps:
cleaning the inside surface of the tube;
coating the inside wall of said tube with the material making up said protective lining, containing silica in aqueous, colloidal, or gelling solution so as to obtain a thin film;
drying said film in ambient air; and
drying said film in an oven at a temperature that is lower than the melting point of the material making up the film.

7. A method according to claim 6, characterized in that said solution is a liquid slip of silica, and in that, prior to the coating step, one of the ends of said tube is closed off, and said slip is fed into said tube via its other end, the tube being opened up again after the coating step.

8. A method according to claim 6 or 7, characterized in that, during said coating step, said tube is rotated about its own axis.

9. A method according to any one of claims 6 to 8, characterized in that, during said drying steps, said tube is rotated about its own axis.
